# EUROPÄISCHE PATENTANMELDUNG

(11) **EP 2 365 516 A1**
(43) Veröffentlichungstag der Anmeldung: **14.09.2011**
(21) Anmeldenummer: 11002268.8
(22) Anmeldetag: 06.03.2008
(51) Int. Cl.: H01J 61/52, H01K 1/58, F21S 8/00, F21V 29/02, H02N 11/00, B64F 1/20

(54) **Beleuchtungsanlage für einen Flugplatz mit Einrichtung zur Kühlung der Lampe**

(30) Priorität: 06.03.2007 DE 102007011260
(62) Teilanmeldung aus: 08004150.2
(71) Anmelder: Quinten, Werner, 66839 Schmelz (DE)
(72) Erfinder: Quinten, Werner, 66839 Schmelz (DE)
(74) Vertreter: Bernhardt, Reinold

(57) **Zusammenfassung**

Die Erfindung betrifft eine Beleuchtungsanlage mit wenigstens einer Leuchte (20), die ein Leuchtelement aufweist, das in einem Gehäuse angeordnet ist, welches einen Reflektor und ein Lichtaustrittsfenster umfasst, und mit Einrichtungen zur Abführung von Wärme von dem Leuchtelement, wobei das Leuchtelement in einer Hülle eingeschlossen ist, welche einen Einlass und einen Auslass für ein an einer Innenwandfläche der Hülle strömendes Kühlmittel aufweist. Erfindungsgemäß steht die Leuchte (20) in Strömungsverbindung mit einem Heizelement (22), das zur Beheizung einer Start- und Landebahn auf einem Flugplatz vorgesehen ist.

## Beschreibung

Die Erfindung betrifft eine Beleuchtungsanlage mit wenigstens einer Leuchte, die ein Leuchtelement aufweist, das in einem Gehäuse angeordnet ist, welches einen Reflektor und ein Lichtaustrittsfenster umfasst, und mit Einrichtungen zur Abführung von Wärme von dem Leuchtelement, wobei das Leuchtelement in einer Hülle eingeschlossen ist, welche einen Einlass und einen Auslass für ein an einer Innenwandfläche der Hülle strömendes Kühlmittel aufweist.

Aus der DE 707 528 C geht eine Beleuchtungsanlage hervor, in der ein KFZ-Scheinwerfer beschrieben ist, dessen Glühlampe von einem Wärmeschutzfilter umgeben ist. Durch einen Raum zwischen dem Wärmeschutzfilter und einem den Wärmeschutzfilter becherartig umschließenden Gefäß wird Kühlluft geführt.

Weitere Leuchten mit einem Leuchtelement, zu dessen Kühlung ein in einer Hülle strömendes Kühlmittel verwendet wird, gehen aus der FR 648 623 A und der DE 10 2004 041 956 A1 hervor.

Der Erfindung liegt die Aufgabe zugrunde, eine Beleuchtungsanlage der eingangs genannten Art zu schaffen, mit der sich die abgeführte Wärme wirksam nutzen lässt.

Die diese Aufgabe lösende Leuchte nach der Erfindung ist dadurch gekennzeichnet, die Leuchte in Strömungsverbindung mit einem Heizelement steht, das zur Beheizung einer Start- und Landebahn auf einem Flugplatz vorgesehen ist.

Die Start- und Landebahn kann durch eine Beheizung mittels des Heizelements schnee- und eisfrei gehalten werden.

Das Heizelement kann zur Aufheizung eines Wärmespeichers dienen. Vorzugsweise kann durch thermoelektrische Elemente eine Umwandlung der Wärmeenergie in elektrische Energie erfolgen.

Weil das Leuchtelement in der genannte Hülle eingeschlossen ist, die den Einlass und den Auslass für das an der Innenwandfläche der Hülle strömendes Kühlmittel aufweist, bleibt die Durchströmung der Leuchte mit Kühlmittel auf die nähere Umgebung des Leuchtelements beschränkt. Die Leuchtkraft beeinträchtigende Ablagerungen am Reflektor werden vermieden. Die in der Umgebung des Leuchtelements konzentrierte Strömung entwickelt eine intensive, Ablagerungen am Leuchtelement bzw. der Hülle verhindernde Spülwirkung.

Zweckmäßig sind Leuchtelement und Hülle in einer Baueinheit zusammengefasst und ggf. einstückig miteinander verbunden. So lässt sich die Leuchte bequem montieren.

In einer bevorzugten Ausführungsform der Erfindung ist das Leuchtelement länglich und die Hülle umfasst eine das Leuchtmittel umgebende Röhre. Das Kühlmittel kann an einem Ende der Röhre in die Röhre ein- und am anderen Ende aus der Röhre ausströmen und dabei gleichmäßig Wärme von dem Leuchtmittel auf dessen gesamter Länge abführen.

In der bevorzugten Ausführungsform weist das Leuchtelement an entgegengesetzten Enden jeweils einen elektrischen Anschlusskontakt auf. Vorzugsweise sind die Anschlusskontakte des Leuchtelements gegen den durchströmten Innenraum der Hülle elektrisch isoliert. Somit ist ein auf Elektrolyse basierender Stromfluss durch das Kühlmedium hindurch ausgeschlossen.

Die Hülle kann aus Glas oder/und einem durchsichtigen Kunststoff bestehen.

Der Ein- und Auslass können im Innenraum des Gehäuses angeordnet und Verbindungsleitungen zu einem Einlass bzw. Auslass am Gehäuse vorgesehen sein. Alternativ liegen der Einlass und der Auslass jeweils an einer Stirnseite der Hülle und, in Längsrichtung des Leuchtelements gesehen, innerhalb der Kontur einer Öffnung am Gehäuse.

Die Erfindung wird nachfolgend anhand von Ausführungsbeispielen und der beiliegenden, sich auf diese Ausführungsbeispiele beziehenden Zeichnungen näher erläutert. Es zeigen:
- Fig. 1: ein Leuchtelement mit einer Hülle in einem Längsschnitt gemäß einem ersten Ausführungsbeispiel für die vorliegende Erfindung,
- Fig. 2: eine Teildarstellung eines Leuchtelements mit einer Hülle in einem Längsschnitt gemäß einem zweiten Ausführungsbeispiel für die Erfindung,
- Fig. 3: eine erfindungsgemäße Leuchte mit einem umhüllten Leuchtelement gemäß Fig. 1 bzw. Fig. 2,
- Fig. 4: die Leuchte von Fig. 3 in einer Seitenansicht,
- Fig. 5: eine Beleuchtungsanlage mit erfindungsgemäßen Leuchten, die in Strömungsverbindung mit einem Heizelement stehen,
- Fig. 6: eine Anlage zur Rückgewinnung elektrischer Energie aus Wärme, die von Leuchten nach der Erfindung abgeführt worden ist, und
- Fig. 7: ein weiteres Leuchtelement mit einer Hülle.

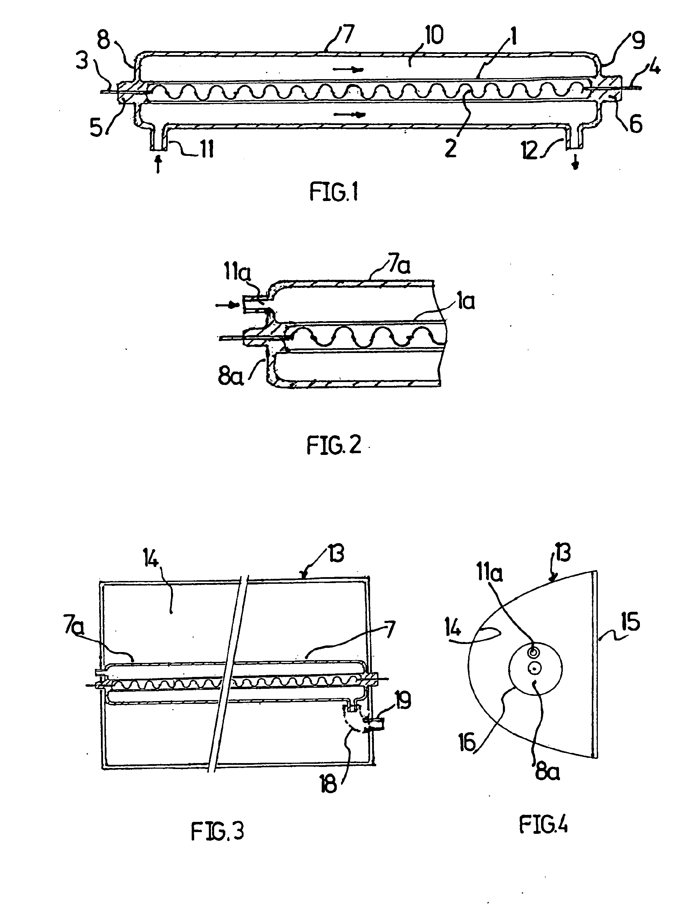

Ein in Fig. 1 gezeigtes Leuchtelement weist eine erste Glasröhre 1 auf, in der ein gewendelter Glühdraht 2 angeordnet ist. Die beiden Enden des Glühdrahts 2 sind jeweils mit einem Anschlusskontaktstift 3 bzw. 4 verbunden, welcher in einen die Glasröhre 1 endseitig verschließenden Glasblock 5 bzw. 6 eingeschmolzen ist.

Die erste Glasröhre 1 umgibt eine zweite, zu der ersten Glasröhre koaxiale Glasröhre 7 mit Stirnwänden 8 und 9, die einstückig mit der ersten Glasröhre 1 bzw. den Glasblöcken 5 und 6 verbunden sind. Ein zwischen der ersten und zweiten Glasröhre gebildeter Raum 10 weist einen Einlass 11 und einen Auslass 12 jeweils in Form eines Anschlussstutzens auf.

Während bei dem Ausführungsbeispiel von Fig. 1 die Ein- und Auslassöffnung in der Röhrenwand vorgesehen und die Anschlussstutzen senkrecht zur Längsachse der Glasröhren verlaufen, weist ein in Fig. 2 gezeigtes Leuchtelement mit einer ersten Glasröhre 1 a und einer zweiten Glasröhre 7a an den Stirnseiten einen Einlass bzw. Auslass auf. In Fig. 2 ist der Einlass 11 a an der Stirnseite 8a gezeigt.

Fig. 3 zeigt Ausführungsbeispiele für Leuchten, wobei auf der linken Seite von Fig. 3 eine Leuchte mit der in Fig. 1 gezeigten Anordnung aus Leuchtelement und Hülle und auf der rechten Seite von Fig. 3 eine Leuchte mit dem in Fig. 2 gezeigten umhüllten Leuchtelement dargestellt ist.

Dementsprechend ist in der Seitenansicht von Fig. 4 der Einlass 1 1 a an der Stirnseite 8a der Hülle sichtbar, und das Gehäuse 14 weist entsprechend große Öffnungen 16 an den Seiten auf, durch die hindurch sich das Leuchtelement sowohl elektrisch als auch an einen Kühlmittelkreislauf anzuschließen lässt.

Bei Verwendung des Leuchtelements von Fig. 1 sind kleinere Öffnungen 17 in den Seitenwänden des Gehäuses 13 vorgesehen. Ein Schlauch 18 verbindet den Ein- bzw. Auslass des Leuchtelements mit einem Einlass bzw. Auslass am Gehäuse. In Fig. 3 ist ein Auslass 19 am Gehäuse 13 gezeigt.

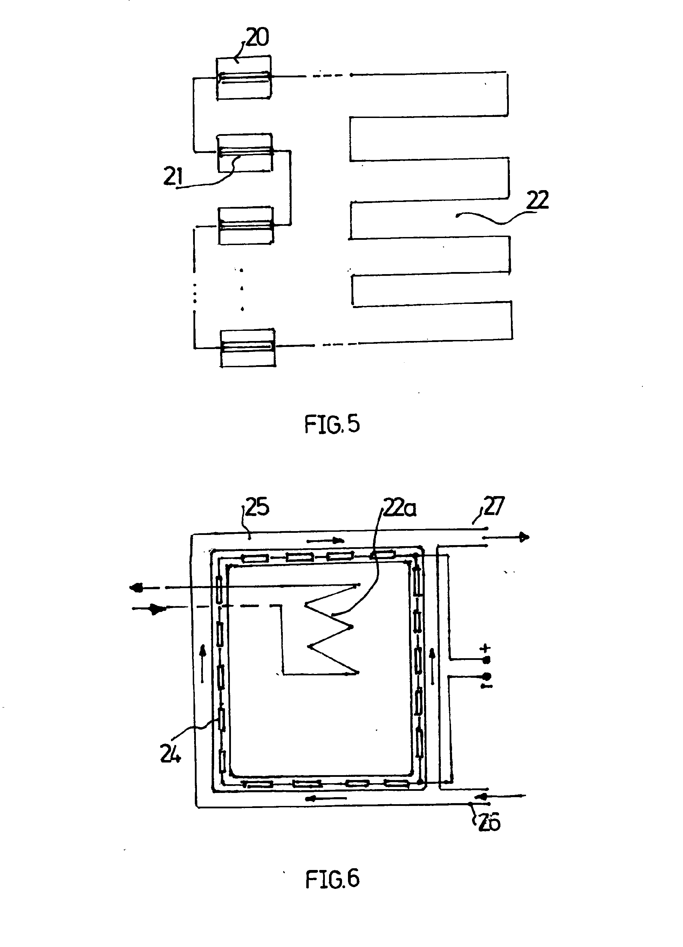

Fig. 5 zeigt schematisch eine Beleuchtungsanlage mit Leuchten 20 nach Fig. 3 oder 4. Die mit einem Kühlmittel, z.B. Wasser, durchströmbaren Innenräume der Leuchtelemente 21 der Leuchten 20 sind in einer Reihenanordnung miteinander verbunden und stehen in Verbindung mit einem Heizelement 22 in Form einer Kühlschlange. Das Heizelement 22 kann z.B. in der Start- und Landebahn eines Flugplatzes eingebettet sein. Als Wärmelieferanten ließen sich sämtliche Leuchten der Beleuchtungsanlage des Flugplatzes einbeziehen.

Es versteht sich, dass Reihen- und Parallelschaltungen der Leuchten miteinander kombiniert werden können.

Ferner könnten Zwischenspeicher, z.B. mit einer Wasserfüllung, zur Aufnahme von Wärme vorgesehen sein.

Gemäß Fig. 4 kann ein dem Heizelement 22 entsprechendes Heizelement 22a Wasser in einem Heißwasserspeicher 23 aufheizen. Der Heißwasserspeicher 23 ist von einer Anordnung parallel und in Reihe geschalteter thermoelektrischer Elemente 24 umgeben, welche einerseits der hohen Temperatur des Heißwasserspeichers 23 und andererseits der niedrigen Temperatur eines Wasserkreislaufs 25 mit einem Zulauf 26 und einem Ablauf 27 ausgesetzt sind. An den Thermoelementen lässt sich bei 28 elektrische Energie abgreifen.

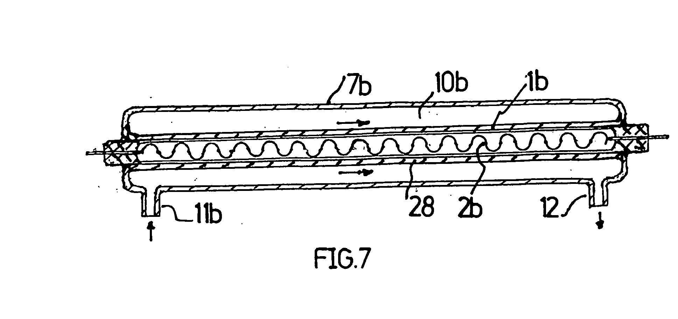

Fig. 7 zeigt eine weitere Anordnung aus einem Leuchtelement 1 b und einer Hülle. Die Hülle besteht aus einem Doppelrohr mit einer Außenröhre 7b und einer Innenröhre 28. Die Innenröhre liegt unmittelbar gegen das Leuchtelement 1 b an, so dass der Wärmedurchgang vom Leuchtelement 1 b in einen mit Kühlmittel durchströmbaren Raum 10b nicht behindert ist.

## Patentansprüche

1. Beleuchtungsanlage mit wenigstens einer Leuchte (20), die ein Leuchtelement (1;1a;1b) aufweist, das in einem Gehäuse (13) angeordnet ist, welches einen Reflektor (14) und ein Lichtaustrittsfenster (15) umfasst, und mit Einrichtungen zur Abführung von Wärme von dem Leuchtelement (1;1a;1b), wobei das Leuchtelement (1;1a;1b) in einer Hülle (7-9;7a,8a;7b) eingeschlossen ist, welche einen Einlass (11;11a;11b) und einen Auslass (12) für ein an einer Innenwandfläche der Hülle (7-9;7a,8a;7b) strömendes Kühlmittel aufweist,
**dadurch gekennzeichnet,**
**dass** die Leuchte (20) in Strömungsverbindung mit einem Heizelement (22;22a) steht, das zur Beheizung einer Start- und Landebahn auf einem Flugplatz vorgesehen ist.

2. Beleuchtungsanlage nach Anspruch 1,
**dadurch gekennzeichnet,**
**dass** das Heizelement (22a) zur Übertragung von Wärme an einen Wärmespeicher vorgesehen ist.

3. Beleuchtungsanlage nach Anspruch 2,
**dadurch gekennzeichnet,**
**dass** thermoelektrische Elemente (24) zur Umwandlung in dem Wärmespeicher (23) gespeicherter Wärme in elektrische Energie vorgesehen sind.

4. Beleuchtungsanlage nach einem der Ansprüche 1 bis 3,
**dadurch gekennzeichnet,**
**dass** das Leuchtelement (1;1a;1b) und die Hülle (7-9;7a,8a;7b) in einer Baueinheit (21) zusammengefasst sind.

5. Beleuchtungsanlage nach einem der Ansprüche 1 bis 4,
**dadurch gekennzeichnet,**
**dass** das Leuchtelement (1;1a,1b) länglich ist.

6. Beleuchtungsanlage nach einem der Ansprüche 1 bis 5,
**dadurch gekennzeichnet,**
**dass** das Leuchtelement (1;1a;1b) an entgegengesetzten Enden jeweils einen Anschlusskontakt (3,4) aufweist.

7. Beleuchtungsanlage nach einem der Ansprüche 1 bis 6,
**dadurch gekennzeichnet,**
**dass** die Anschlusskontakte (3,4) des Leuchtelements (1;1a;1b) gegen den durchströmten Innenraum (10;10b) der Hülle (7-9;7a,8a;7b) elektrisch isoliert sind.

8. Beleuchtungsanlage nach einem der Ansprüche 1 bis 7,
**dadurch gekennzeichnet,**
**dass** die Hülle (7-9;7a,8a;7b) Glas oder/und einen Kunststoff aufweist.

9. Beleuchtungsanlage nach einem der Ansprüche 1 bis 8,
**dadurch gekennzeichnet,**
**dass** der Ein- und Auslass (11, 12; 11a;11b) im Innenraum des Gehäuses (13) angeordnet und Verbindungsleitungen (18) zu einem Einlass bzw. Auslass am Gehäuse (13) vorgesehen sind.

10. Beleuchtungsanlage nach einem der Ansprüche 1 bis 9,
**dadurch gekennzeichnet,**
**dass** der Einlass (11a) und der Auslass in Längsrichtung des Leuchtelements gesehen innerhalb der Kontur einer Öffnung (16) im Gehäuse (13) liegen.

11. Beleuchtungsanlage nach einem der Ansprüche 1 bis 10,
**dadurch gekennzeichnet,**
**dass** die Hülle ein Doppelrohr mit einer Außenröhre (7b) und einer Innenröhre (28) umfasst, wobei die Innenröhre (28) gegen das Leuchtelement (1b) anliegt und das Leuchtelement (1b) in der Innenröhre (28) verschiebbar ist.
